# DEMANDE DE BREVET EUROPEEN

(11) **EP 1 876 602 A1**
(43) Date de publication de la demande: **09.01.2008**
(21) Numéro de dépôt: 07111496.1
(22) Date de dépôt: 02.07.2007
(51) Int. Cl.: G11C 11/406

(54) **Procédé de rafraîchissement d'une mémoire vive dynamique et dispositif de mémoire vive dynamique corrrespondant, en particulier incorporé dans un téléphone mobile cellulaire**

(30) Priorité: 03.07.2006 FR 0605988
(71) Demandeur: STMicroelectronics SA, 92120 Montrouge (FR)
(72) Inventeur: Harrand, Michel, 38120 Saint Egrève (FR)
(74) Mandataire: Zapalowicz, Francis

(57) **Abrégé**

L'invention vise un procédé de rafraîchissement d'une mémoire vive dynamique couplée à un système de correction d'erreur qui utilise un code correcteur d'erreur, ladite mémoire comprenant des groupes de cellules-mémoire aptes à stocker des bits, chaque groupe de cellules-mémoire étant subdivisé en paquets de cellules-mémoire. A chaque paquet de cellules-mémoire sont adjoints quelques bits formant ledit code correcteur d'erreur. On effectue sur chaque groupe de cellules-mémoire, un test de rétention dans lequel on sauvegarde le groupe sous test dans une zone mémoire sûre, après une correction de ses éventuelles erreurs par ledit système de correction d'erreur, de façon à obtenir un groupe modèle comportant des paquets modèles (étape 32) ; on effectue au bout d'une période de latence, une comparaison bit-à-bit entre le groupe modèle et ledit groupe n'ayant ni été corrigé ni rafraîchi pendant ladite période de latence ; on détecte dans chaque paquet dudit groupe, les bits dits erronés ayant des valeurs différentes de celles des bits du paquet modèle correspondant et on considère ledit paquet comme erroné s'il comporte un nombre de bits erronés supérieur à une valeur limite inférieure ou égale au nombre de bits capable d'être corrigés par le système de correction d'erreur (étape 39), et on augmente la valeur de la fréquence de rafraîchissement de la mémoire, si le nombre de groupes de cellules-mémoire comportant au moins un paquet erroné, est supérieur à un seuil fixé (étape 40a).

## Description

L'invention concerne les mémoires vives dynamiques, c'est-à-dire nécessitant un rafraîchissement périodique des données que contiennent les cellules-mémoire de ces mémoires. Et, l'invention concerne plus particulièrement le rafraîchissement de ces mémoires vives dynamiques.

L'invention s'applique avantageusement, mais non limitativement, aux téléphones mobiles cellulaires qui incorporent des mémoires vives dynamiques.

Les téléphones mobiles cellulaires de troisième génération vont nécessiter l'intégration de grandes quantités de mémoire. Cependant, le coût du produit doit rester faible. L'utilisation de mémoires vives dynamiques (DRAM) à la place des mémoires vives statiques (SRAM) utilisées aujourd'hui, permet cet accroissement de capacité de mémoire pour un faible coût.

Cependant, une contrainte importante dans ce type d'application, est la faible consommation électrique pendant que le téléphone est en veille, afin de ne pas décharger les batteries trop vite. Or, si les mémoires vives dynamiques ont un courant de fuite statique plus faible que les mémoires vives statiques, elles nécessitent en revanche d'être continuellement rafraîchies si l'on doit conserver les données en mode « veille ». Et, ce rafraîchissement nécessite une consommation d'énergie qu'il importe de minimiser. La fréquence de rafraîchissement est donnée par le nombre de pages-mémoire à rafraîchir et par le temps de rétention de la mémoire. Ce temps de rétention est essentiellement lié aux fuites de jonction des transistors des cellules-mémoire.

On connaît par la demande de brevet n°03 01 005 au nom de la Demanderesse, un procédé de rafraîchissement des mémoires vives, qui utilise la mesure du temps de rétention réel de toutes les cellules-mémoire de la mémoire pour réguler la période de rafraîchissement de cette dernière.

Plus précisément, pour un groupe de cellules-mémoire sélectionnées, on observe le nombre d'erreurs accumulées, lorsque l'on diminue la fréquence de rafraîchissement de ces cellules-mémoire. On compare le nombre d'erreurs comptabilisées à un seuil prédéterminé, et selon le résultat de cette comparaison, la période de rafraîchissement est augmentée ou diminuée.

Cependant, outre les erreurs liées aux fuites de jonction des transistors des cellules-mémoire, certaines erreurs sont dues à un défaut matériel de la cellule-mémoire, du fait de l'usure des composants de la mémoire, par exemple.

Classiquement, pour prévenir ce type d'erreur, le circuit de mémoire subit préalablement à sa mise en service, une opération dite de déverminage (« burn-in » en langue anglaise). Cette opération consiste à imposer aux cellules-mémoire de la mémoire des contraintes de fonctionnement défavorables, de manière à éliminer les circuits de mémoire susceptibles de ne plus fonctionner à court terme.

En l'absence d'une opération de déverminage préalable, des erreurs dues à des cellules-mémoire défectueuses, par exemple ayant un temps de rétention extrêmement faible, pourraient apparaître au cours de l'utilisation de la mémoire sur un certain nombre de pièces, dégradant ainsi le niveau de qualité des produits.

Cependant, si l'opération de déverminage est intéressante pour éliminer les circuits comprenant les cellules-mémoire défectueuses précitées, elle est particulièrement coûteuse.

Un autre inconvénient réside dans le test de la cellule-mémoire qui est généralement effectué. Celui-ci consiste à imposer la valeur « 1 » (correspondant à une tension maximale aux bornes du condensateur de la cellule-mémoire) à tous les bits des paquets de cellules-mémoire testés (après avoir sauvegardé à part la véritable valeur de ces bits). Puis au bout d'une période de latence, on comptabilise les bits étant passés à « 0 » (voir la demande de brevet n°03 01 005 au nom de la Demanderesse), en raison d'une fuite de la jonction du transistor d'une cellule-mémoire plus faible.

Or les cellules-mémoire faibles devant mémoriser la valeur « 0 » ne posent pas de problème de mémorisation. Par conséquent, en imposant la valeur de « 1 » à tous les bits, on détecte toutes les cellules-mémoire faibles, même celles dont le défaut n'a pas d'importance, étant donné qu'elles doivent sauvegarder le bit « 0 ». En conséquence, on augmente la fréquence de rafraîchissement pour des cellules-mémoire dont les fuites n'ont pas d'influence sur les données mémorisées.

L'invention vise à apporter une solution à ces problèmes.

Un but de l'invention est de proposer un dispositif de rafraîchissement d'une mémoire vive dynamique auquel on n'a pas fait subir d'opération de déverminage mais dans lequel la période de rafraîchissement est néanmoins régulée de manière optimale, de façon à limiter la consommation du dispositif.

Un autre but de l'invention est de diminuer encore la consommation engendrée par le rafraîchissement de la mémoire, notamment en améliorant le test effectué au niveau des cellules-mémoire.

Comme le mécanisme de mesure de la rétention peut être un peu lent (ce qui ne pose pas de problème si la température évolue lentement), un autre but de l'invention est de prévoir des moyens pour parer aux éventuels problèmes apparaissant si la température monte plus vite que le système ne mesure la rétention, étant donné que la température influe sur le temps de rétention des cellules-mémoire.

Selon un premier aspect de l'invention, il est proposé un procédé de rafraîchissement d'une mémoire vive dynamique couplée à un système de correction d'erreur qui utilise un code correcteur d'erreur (« Error Correcting Code » ou ECC en langue anglaise), ladite mémoire comprenant des groupes de cellules-mémoire aptes à stocker des bits, chaque groupe de cellules-mémoire étant subdivisé en paquets de cellules-mémoire.

Selon un caractéristique générale de cet aspect de l'invention, à chaque paquet de cellules-mémoire sont adjoints quelques bits formant ledit code correcteur d'erreur, et on effectue sur chaque groupe de cellules-mémoire, un test de rétention dans lequel
on sauvegarde le groupe sous test dans une zone mémoire sûre (c'est-à-dire une mémoire conçue pour éviter les erreurs liées à des fuites de jonction, telle une mémoire statique ou une mémoire vive dynamique rafraîchie à fréquence élevée ; l'utilisateur n'a pas accès à cette zone de mémoire sûre), après une correction de ses éventuelles erreurs par ledit système de correction d'erreur, de façon à obtenir un groupe modèle comportant des paquets modèles,
on effectue au bout d'une période de latence, une comparaison bit-à-bit entre le groupe modèle et ledit groupe n'ayant ni été corrigé ni rafraîchi pendant ladite période de latence,
on détecte dans chaque paquet dudit groupe, les bits dits erronés ayant des valeurs différentes de celles des bits du paquet modèle correspondant et on considère ledit paquet comme erroné s'il comporte un nombre de bits erronés supérieur à une valeur limite inférieure ou égale au nombre de bits capable d'être corrigés par le système de correction d'erreur, et
on augmente la valeur de la fréquence de rafraîchissement de la mémoire, si le nombre de groupes de cellules-mémoire comportant au moins un paquet erroné, est supérieur à un seuil fixé.

En d'autres termes, on élabore un groupe modèle pour chaque groupe de cellules (par exemple pour chaque page-mémoire de la mémoire), et on compare ce groupe modèle avec le contenu non-corrigé et non rafraîchi pendant une certaine durée, du même groupe de cellules mémoire.

Si à l'issue de la comparaison des deux groupes (modèle et non rafraîchi), le nombre d'erreurs observées pour l'un des paquets du groupe (par exemple pour un mot) est supérieur au nombre d'erreurs que le code correcteur d'erreurs est capable de corriger (plus généralement supérieur à une valeur limite inférieure ou égale à ce nombre d'erreurs), on considère que le mot en question est erroné. Si un ou plusieurs groupes de cellules-mémoire comprennent au moins un mot erroné, on augmente la fréquence de rafraîchissement de la mémoire. Si lorque toutes les pages ont été testées, aucune page ne contient un mot présentant plus d'une erreur (plus de k erreurs dans le cas général, avec k≤ N, N étant le nombre d'erreurs que peut corriger le système de correction d'erreur, en fonction du code correcteur d'erreur utilisé), la fréquence de référence de la mémoire est légèrement diminuée.

En effet, l'utilisation d'un système de correction d'erreur, permet d'ignorer un certain nombre d'erreurs (selon le nombre d'erreurs qu'est capable de corriger le système de correction d'erreur en question), puisqu'à chaque fois que la donnée erronée sera transférée hors de la mémoire, il corrigera automatiquement ces erreurs.

De cette façon, on ne comptabilise pas systématiquement une erreur si une cellule-mémoire, même ayant des fuites de jonction, doit mémoriser le bit « 0 ».

De préférence, le système de correction d'erreur est capable de corriger un bit par paquet de cellules-mémoire.

Dans ce cas, le code correcteur d'erreur a pour avantage d'être particulièrement simple à mettre en oeuvre.

Ladite période de latence peut comprendre N périodes de rafraîchissement, N étant un entier.

Selon un mode de mise en oeuvre, à l'issue de la détection des bits erronés, on adjoint un code correcteur d'erreur au contenu du groupe de cellules-mémoire modèle, puis on le sauvegarde au sein de la mémoire vive dynamique, à la place du groupe de cellules-mémoire correspondant.

Selon un mode de mise en oeuvre, tant que le nombre de groupes de cellules-mémoire comportant au moins un paquet erroné, dit groupes de cellules-mémoire faibles, est inférieur ou égal audit seuil fixé (c'est-à-dire k tel que k≤N, N étant le nombre d'erreurs que peut corriger le système de correction d'erreur en fonction du code de correction d'erreur qui a préalablement été utilisé), on mémorise l'adresse du groupe de cellules-mémoire faibles pour les rafraîchir à la fréquence maximale.

Selon un mode de mise en oeuvre, l'augmentation est effectuée si la fréquence de rafraîchissement n'a pas atteint sa valeur maximale.

De préférence, lorsque tous les groupes de cellules-mémoire de la mémoire ont été testés, on diminue la valeur de la fréquence de rafraîchissement, si elle n'a pas été augmentée au cours dudit test.

Lorsque tous les groupes de cellules-mémoire de la mémoire ont été testés, si le nombre de groupes de cellules-mémoire comportant au moins un paquet erroné, dit groupe de cellules-mémoire faibles, est supérieur ou égal audit seuil fixé et si la fréquence de rafraîchissement est à sa valeur maximale, on peut considérer comme nul ledit nombre de groupes de cellules-mémoire faibles.

Selon un mode de mise en oeuvre, on sélectionne successivement chaque groupe de cellules-mémoire formant un groupe de cellules de test, de façon à effectuer ledit test de rétention.

De préférence parallèlement au test de rétention, on rafraîchit cycliquement l'ensemble des cellules-mémoire de la mémoire à l'exception du groupe de cellule de test.

Par exemple, la mémoire peut être organisée par page et chaque groupe de cellules-mémoire peut correspondre à un nombre entier de pages, et chaque paquet de cellules-mémoire correspond à un mot d'une page.

On peut imposer une augmentation de la fréquence de rafraîchissement si la variation de la température au sein de ladite mémoire dépasse un seuil choisi.

Par exemple, la mémoire peut être incorporée dans un appareil possédant un mode de veille et un mode de fonctionnement actif. On effectue le test de rétention sur toutes les cellules-mémoire au moins au cours du mode de veille.

Ledit appareil peut être un composant d'un système de communication sans fil, par exemple un téléphone mobile cellulaire.

Selon un autre aspect de l'invention, il est proposé un dispositif de rafraîchissement d'une mémoire vive dynamique comprenant des groupes de cellules-mémoire aptes à stocker des bits, chaque groupe de cellules-mémoire étant subdivisé en paquets de cellules-mémoire.

Selon une caractéristique générale de l'invention, la mémoire vive dynamique est couplée à un système de correction d'erreur en vue duquel un code correcteur d'erreurs, apte à corriger un nombre donné de bits erronés éventuels par paquet de cellules-mémoire, est associé à chaque paquet de cellules-mémoire. Le dispositif comprend des moyens de test aptes à effectuer un test de rétention sur chaque groupe de cellules-mémoire, comportant
une zone de mémoire sûre apte à sauvegarder le groupe sous test après une correction de ses éventuelles erreurs par ledit système de correction d'erreur, de façon à obtenir un groupe modèle comportant des paquets modèles,
des moyens de comparaison aptes à effectuer au bout d'une période de latence, une comparaison bit-à-bit entre le groupe modèle et ledit groupe n'ayant ni été corrigé, ni rafraîchi pendant ladite période de latence, et apte à détecter dans chaque paquet dudit groupe, les bits dits erronés ayant des valeurs différentes de celles des bits du paquet modèle correspondant et aptes à considérer ledit paquet comme erroné s'il comporte un nombre de bits erronés supérieur à une valeur limite inférieure ou égale au nombre de bits capable d'être corrigés grâce au code correcteur d'erreur, par le système de correction d'erreur. Le dispositif comprend des moyens d'augmentation aptes à augmenter la valeur de la fréquence de rafraîchissement de la mémoire, si le nombre de groupes de cellules-mémoire comportant au moins un paquet erroné, est supérieur à un seuil fixé.

Selon un mode de réalisation, ladite zone de mémoire sûre est une zone réservée de ladite mémoire vive, rafraîchie à la valeur maximale de la fréquence de rafraîchissement, pour sauvegarder le groupe modèle.

Selon un autre mode de réalisation, ladite zone de mémoire sûre est une mémoire statique annexe couplée à la mémoire vive dynamique, pour sauvegarder le groupe modèle.

Le dispositif peut comprendre en outre des moyens d'adjonction couplés à ladite mémoire vive dynamique, aptes à adjoindre un code correcteur d'erreur au contenu du groupe de cellules-mémoire modèle, et aptes à sauvegarder le contenu codé du groupe modèle au sein de la mémoire vive dynamique, à la place du groupe de cellules-mémoire correspondant.

Par exemple, le dispositif peut comprendre en outre une mémoire de pages faibles, dont la taille est égale audit seuil, aptes à sauvegarder les adresses des groupes de cellules-mémoire comportant au moins un paquet erroné, dit groupes de cellules-mémoire faibles.

Les groupes de cellules-mémoire faibles sont avantageusement rafraîchis à la valeur maximale de rafraîchissement.

Le dispositif peut comprendre en outre des moyens de comparaison aptes à comparer le remplissage de la mémoire de pages faibles et ledit seuil.

Le dispositif peut comprendre en outre des moyens d'enregistrement aptes à enregistrer la réalisation d'une augmentation de la fréquence.

Le dispositif peut comprendre en outre des moyens de diminution couplés auxdits moyens d'enregistrement, aptes à diminuer la fréquence de rafraîchissement.

Le dispositif peut comprendre en outre des moyens de contrôle de la mémoire de pages faibles, aptes à mettre à jour et à réinitialiser ladite mémoire de pages faibles.

Les moyens de test de rétention peuvent comprendre en outre des moyens de sélection aptes à sélectionner successivement les différents groupes de cellules-mémoire, de façon à balayer l'ensemble des cellules-mémoire, les groupes de cellules-mémoire sélectionnés formant des groupes de cellules de test.

Le dispositif peut comprendre en outre des moyens de rafraîchissement aptes à rafraîchir cycliquement l'ensemble des cellules-mémoire de la mémoire.

Le dispositif peut comprendre en outre des moyens de comparaison auxiliaires couplés entre les moyens de rafraîchissement et les moyens de test, aptes à comparer les adresses du groupe de cellules-mémoire rafraîchi par les moyens de rafraîchissement, et du groupe de cellules de test, de façon que les moyens de rafraîchissement ne rafraîchissent pas le groupe de cellules de test.

De préférence, ledit système de correction d'erreur est apte à corriger une erreur par paquet de cellule-mémoire.

Dans ce cas, si chaque paquet de cellules-mémoire comprend n bits, et les moyens de comparaison comprennent de préférence, pour chaque paquet d'un groupe de cellules-mémoire, n portes logiques « OU EXCLUSIF », chaque porte étant apte à recevoir l'un des bits du paquet modèle et le bit correspondant du paquet n'ayant ni été corrigé ni rafraîchi pendant ladite période de latence, n portes logiques « ET » avec n-1 entrées inverseuses, et une porte logique « ET » avec n entrées inverseuses, l'ensemble des portes logiques « ET » étant connectées en parallèle, à la sortie des n portes logiques « OU EXCLUSIF », et une porte logique « OU » connectée à la sortie de l'ensemble des portes logiques « ET », apte à déterminer s'il existe au moins deux bits différents entre ledit paquet modèle et ledit bit correspondant du paquet n'ayant ni été corrigé ni rafraîchi pendant ladite période de latence.

En variante,si chaque paquet de cellules-mémoire comprend n bits, les moyens de comparaison peuvent comprendre n portes logiques « OU EXCLUSIF », chaque porte étant apte à recevoir l'un des bits du paquet modèle et le bit correspondant du paquet n'ayant ni été corrigé ni rafraîchi pendant ladite période de latence, n-1 demi-additionneurs (ADi) connectés en série et en sortie des portes logiques « OU EXCLUSIF », aptes à recevoir, pour le premier demi-additionneur, les signaux de sortie des 2 premières portes « OU exclusif », et pour les autres, d'une part une somme délivrée par le demi-additionneur connecté en amont, et d'autre part un signal de sortie d'une porte logique « OU EXCLUSIF », chaque demi-additionneur étant apte à délivrer un signal de retenue. Les moyens de comparaison comprennent en outre des moyens d'addition de l'ensemble desdites retenues, aptes à déterminer s'il existe au moins deux bits différents entre ledit paquet modèle et ledit bit correspondant du paquet n'ayant ni été corrigé, ni rafraîchi pendant ladite période de latence.

Selon cette variante, les moyens d'addition comprennent une porte logique « OU » dont les entrées sont connectées aux sorties des deux premiers demi-additionneurs et, si n est supérieur à 3, n-3 portes logiques « OU » (ORi) recevant en entrée le signal de sortie de la porte logique « OU » connectée en amont, et la retenue du demi-additionneur associé.

Selon une autre variante, si chaque paquet de cellules-mémoire comprend n bits, les moyens de comparaison peuvent comprendre n portes logiques « OU EXCLUSIF », chaque porte étant apte à recevoir l'un des bits du paquet modèle et le bit correspondant du paquet n'ayant ni été corrigé ni rafraîchi pendant ladite période de latence, un multiplexeur commandé par un compteur cadencé par un signal d'horloge et couplé à la sortie des n portes logiques « OU EXCLUSIF », un demi-additionneur couplé à la sortie du multiplexeur, une première bascule connectée à la sortie du demi-additionneur, et dont la sortie est rebouclée à l'entrée dudit demi-additionneur, et une deuxième bascule connectée au demi-additionneur par l'intermédiaire d'une porte logique « OU », apte à déterminer s'il existe au moins deux bits différents entre ledit paquet modèle et ledit bit correspondant du paquet n'ayant ni été corrigé, ni rafraîchi pendant ladite période de latence.

Le demi-additionneur peut être simplifié en utilisant une simple porte « OU » pour déterminer la somme au lieu d'une porte « OU EXCLUSIF ».

Par exemple, la mémoire est organisée par page et chaque groupe de cellules de test correspond à un nombre entier de pages, et chaque paquet de cellules-mémoire correspond à un mot d'une page.

De préférence, le dispositif comprend en outre des moyens de commandes aptes à commander les moyens de rafraîchissement et les moyens de test de rétention.

De préférence, le dispositif comprend en outre un capteur de température, couplé aux moyens de commande, aptes à détecter une variation de la température.

Selon un autre aspect de l'invention, il est proposé un appareil possédant un mode de veille et un mode de fonctionnement actif, incorporant un dispositif tel que décrit précédemment.

Les moyens de test effectuent le test de rétention sur toutes les cellules-mémoire au cours du mode de veille.

L'appareil peut former un composant d'un système de communication sans fil.

L'appareil peut former un téléphone mobile cellulaire.

D'autres avantages et caractéristiques de l'invention apparaîtront à l'examen de la description détaillée d'un mode de mise en oeuvre et de réalisation, nullement limitatif, et des dessins annexés sur lesquels :
- la figure 1 illustre très schématiquement une mémoire vive selon l'invention au sein de laquelle les cellules sont successivement regroupées en lignes,
- la figure 2 illustre plus en détail mais toujours schématiquement un dispositif de mémoire selon l'invention et plus particulièrement les moyens auxiliaires de traitement associés à la mémoire vive selon l'invention,

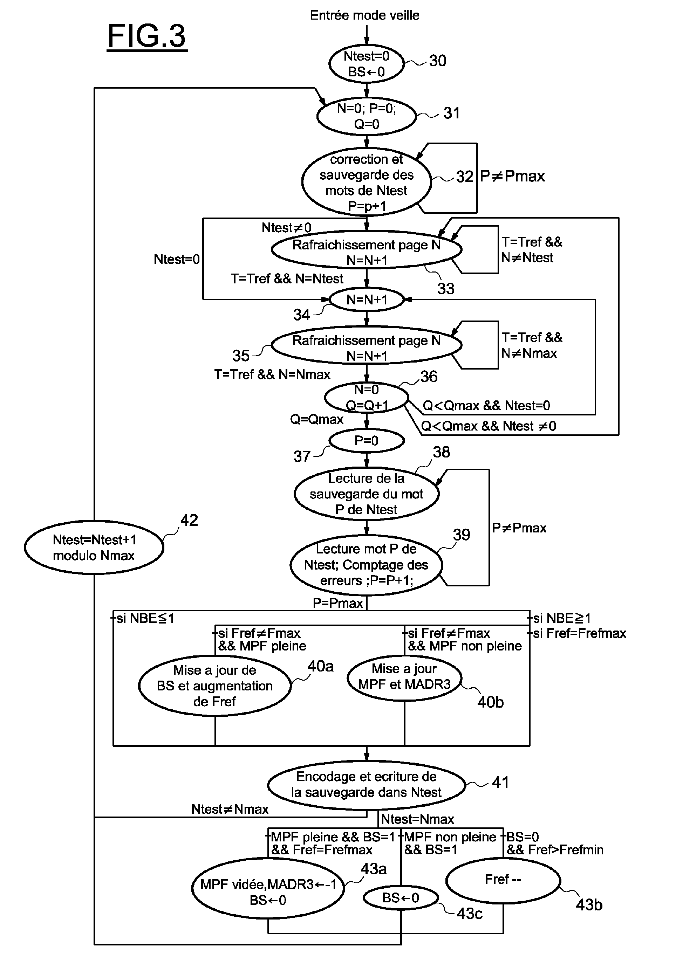

- la figure 3 représente un organigramme schématique d'un mode de mise en oeuvre du procédé selon l'invention,
- les figures 4 à 6 illustrent des modes de réalisation des moyens de comparaison selon l'invention, et
- la figure 7 illustre un mode de réalisation de moyens délivrant une information sur la température du dispositif de mémoire selon l'invention,

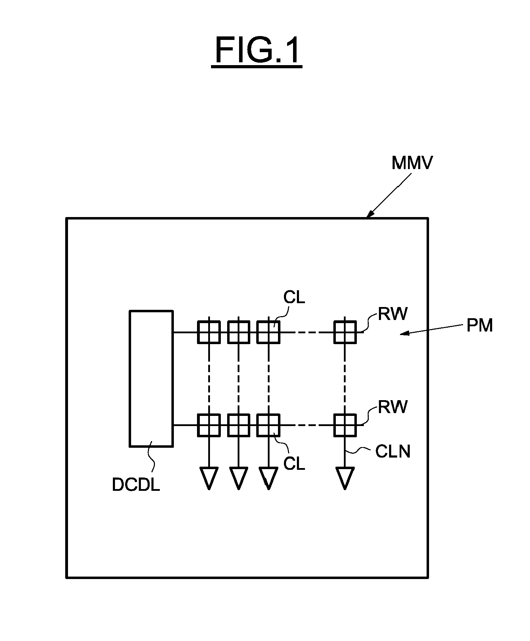

Sur la figure 1, la référence MMV désigne une mémoire vive dynamique selon l'invention dont le plan-mémoire PM comporte un réseau matriciel de cellules-mémoire CL typiquement organisé en rangées (lignes) RW et en colonnes CLN. Chaque cellule-mémoire comporte généralement un transistor et un condensateur.

Par ailleurs, de façon classique et connue en soi, le plan-mémoire PM est connecté à un décodeur-lignes DCDL et un décodeur-colonnes (non représenté ici à des fins de simplification).

D'une manière générale, selon l'invention, on mesure continuellement et dynamiquement sur la puce (circuit intégré) contenant la mémoire MMV, le temps de rétention de toutes les cellules de la mémoire, et on va ajuster la période de rafraîchissement de cette mémoire en conséquence.

Dans l'exemple décrit ici, la mémoire est organisée en pages-mémoire, une page correspondant à une ligne de mots.
Et, avant de revenir plus en détail sur l'algorithme d'ajustement de la période de rafraîchissement, on peut d'ores et déjà décrire les grandes lignes d'un mode de mise en oeuvre qui consiste à rafraîchir moins vite, par exemple deux fois moins vite que les pages restantes, une page-mémoire sélectionnée qualifiée de page de test, et d'observer si cela provoque des erreurs ou non.

On répète l'opération sur toute la mémoire en changeant à chaque fois de page de test. L'apparition d'erreurs dans le contenu non rafraîchi pendant deux périodes, indique que la valeur de la fréquence de rafraîchissement est trop faible.

Plus précisément, avant de rafraîchir moins vite une page de test, on élabore un modèle de la page de test. Pour ce faire, on sauvegarde dans une partie réservée de la mémoire vive, pendant une période de latence, le contenu de la page de test, que l'on rafraîchit à la fréquence maximale de rafraîchissement. De cette façon, on prévient les fuites de jonction.

En variante, il est possible de sauvegarder le contenu de la page de test dans une mémoire statique externe au lieu d'une partie réservée de la mémoire vive.

Par ailleurs, l'invention tire parti de la présence d'un système de correction d'erreurs destiné à protéger la mémoire des défauts pouvant provenir lors de la vie du circuit pour diminuer la fréquence de rafraîchissement de la mémoire, et par conséquent sa consommation en mode veille ; en effet, les seules opérations effectuées en mode veille sur la mémoire sont ces rafraîchissements.

Le système de protection de la mémoire fonctionne de la manière suivante : à chaque écriture d'une donnée dans la mémoire par le système utilisateur, un code correcteur d'erreur est calculé à partir de la donnée, adjoint à cette donnée et mémorisée avec elle. A chaque lecture de cette donnée, la cohérence entre cette donnée et le code correcteur qui lui est associée est vérifiée, et dans le cas où une erreur est détectée, celle-ci est corrigée.

Le nombre d'erreurs corrigées dépend de l'algorithme du code correcteur utilisé. Dans la suite de la description, sauf indication contraire, on considèrera qu'une seule erreur peut être corrigée par le code correcteur.

A l'issue de la période de latence (correspondant par exemple à deux périodes de rafraîchissement si l'on rafraîchit le contenu de la page de test deux fois moins vite), on compare la page modèle avec le contenu non corrigé et non rafraîchi de la page de test, auquel le code correcteur d'erreurs n'est pas appliqué.

Si lorsque toutes les pages ont été testées, aucune page ne contient un mot présentant plus d'une erreur (plus de k erreurs, dans le cas général, avec k≤N, N étant le nombre d'erreurs que peut corriger le système de correction d'erreur en fonction du code correcteur d'erreurs utilisé), la fréquence de rafraîchissement de la mémoire est légèrement diminuée.

Sinon, sous réserve d'une gestion adaptée des pages-mémoire les plus faibles comme on le verra ci-après, on augmente légèrement la fréquence de rafraîchissement de la mémoire.

Ainsi, la mémoire auto-ajuste sa période de rafraîchissement à ce qui lui est nécessaire.

De façon que les pages de la mémoire qui possèdent des cellules-mémoire avec un temps de rétention plus faible que les autres pages-mémoire (dites pages-faibles), ne pénalisent pas la fréquence de rafraîchissement de l'ensemble de la mémoire, il est possible de stocker à part les adresses des Vmax premières pages faibles détectées, de façon à les rafraîchir à la fréquence de rafraîchissement maximale.

Elles ne seront donc pas prises en compte pour la détermination de la fréquence de rafraîchissement de la mémoire.

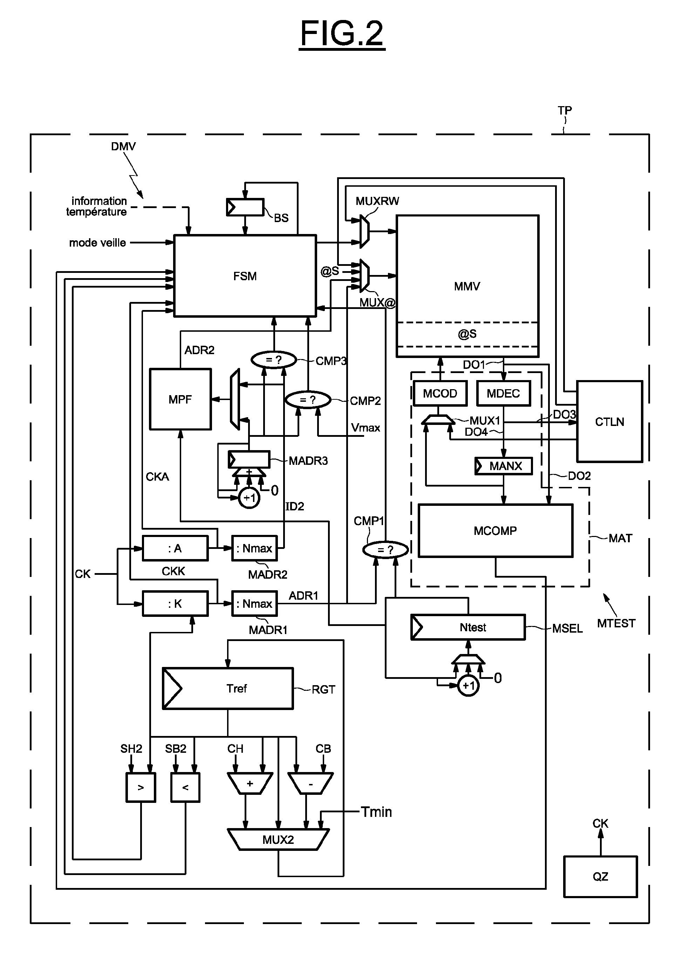

Afin de mettre en oeuvre le mécanisme de régulation de la fréquence de rafraîchissement de la mémoire vive MMV, le dispositif de mémoire DMV selon l'invention comporte (figure 2) outre la mémoire MMV, des moyens de test de rétention MTEST, et en particulier des moyens auxiliaires de traitement MAT dont on va maintenant décrire plus en détail la structure et les fonctionnalités.

Dans une application particulière de l'invention, ce dispositif est incorporé dans un téléphone mobile cellulaire TP.

Le dispositif de mémoire DMV comprend des moyens de commande FSM, cadencés par un signal CKK obtenu à partir d'un signal d'horloge CK. Celui-ci est par exemple généré par un oscillateur à quartz QZ.

Le signal CK est délivré à un diviseur par K, à rapport ajustable, de façon que la fréquence du signal CKK permette de balayer l'ensemble des pages de la mémoire, soit Nmax pages mémoire.

La valeur de K est ajustée en fonction de la fréquence de rafraîchissement choisie, c'est-à-dire par rapport au temps de rétention observé pour les cellules-mémoire de la mémoire MMV, comme on le verra ci-après.

Les moyens de commande FSM envoient donc la commande de rafraîchissement d'une page de la mémoire avec une période de Tret/Nmax, Tret étant le temps de rétention observé pour les cellules-mémoire de la mémoire MMV.

Un compteur/diviseur par Nmax, MADR1, est connecté à la sortie du diviseur par K. Il délivre en sortie une adresse ADR1 de la page mémoire de la mémoire MMV à rafraîchir.

L'adresse ADR1 est transmise à la mémoire MMV par l'intermédiaire d'un multiplexeur MUX@, commandé par les moyens de commande FSM comme l'ensemble des registres et multiplexeurs du dispositif DMV mentionnés par la suite.

Une commande de rafraîchissement de la page mémoire à l'adresse ADR1 est envoyée par les moyens FSM vers la mémoire MMV via un multiplexeur MUXRW.

Par ailleurs, pour déterminer le temps de rétention des cellules-mémoire de la mémoire le dispositif DMV comprend des moyens de sélection MSEL des pages de la mémoire à tester et des moyens auxiliaires de traitement MAT formant des moyens de test pour effectuer le test de rétention. Ces derniers permettent d'ajuster la valeur de K précitée.

Pour ce faire, les moyens de sélection MSEL balaient la mémoire MMV de manière à sélectionner successivement chaque page de la mémoire. Ils délivrent alors une adresse Ntest d'une page-mémoire sélectionnée, autrement dit une page de test.

Les moyens de sélection MSEL sont commandés par les moyens de commande FSM par l'intermédiaire d'un multiplexeur connecté à leur entrée. Selon la commande des moyens FSM, les moyens de sélection MSEL peuvent être soit remis à zéro, soit incrémentés d'une unité, soit maintenus à leur valeur en cours.

Une page-mémoire sélectionnée (page de test) n'est pas rafraîchie par les moyens de commande FSM. Pour cela, le dispositif DMV comprend un comparateur auxiliaire CMP1 recevant en entrée les adresses ADR1 et Ntest. Si les deux adresses correspondent, les moyens de commande FSM passent le rafraîchissement de la page-mémoire en question.

La page de test sélectionnée est traitée par les moyens auxiliaires de traitement MAT. Ces derniers comprennent des moyens de décodage MDEC connectés à la sortie de la mémoire vive MMV par l'intermédiaire d'un bus de sortie DO1. Les moyens de décodage MDEC forment le système de correction d'erreur.

En outre, comme déjà mentionnée ci-avant, un code correcteur d'erreur (ECC) (par exemple le code de Hamming, bien connu de l'homme du métier, dont une version est décrite sur le site : **http:// burtleburtle.net/bob/math/errorcorr.htlm)**, permet la correction d'un bit par paquet de cellules-mémoire.

Le code correcteur d'erreur consiste en des bits supplémentaires ajoutés à chaque mot lors de leur écriture dans la mémoire. Ces bits supplémentaires sont traités par les moyens de décodage MDEC lorsque le mot est lu, de façon à détecter et corriger k éventuelles erreurs par mot (par exemple 1 erreur par mot).

Ainsi, les moyens de décodage MDEC permettent de corriger les erreurs éventuelles des données de la mémoire grâce à l'utilisation des bits supplémentaires constituant le code correcteur d'erreur implémenté au sein du dispositif de mémoire comme mentionné ci-avant.

On considère dans cet exemple que le contenu modèle de la page de test est sauvegardée dans une partie réservée de la mémoire MMV (zone de mémoire sûre), d'adresse @S, que l'utilisateur n'a pas le droit d'utiliser.

(En variante la zone de mémoire sûre peut être une mémoire statique couplée à la mémoire vive.)

La partie réservée de la mémoire MMV, d'adresse @S, sert à sauvegarder le contenu modèle de la page de test, tel que décrit ci-avant.

La partie réservée d'adresse @S de la mémoire, peut par exemple être rafraîchie à la fréquence maximale de rafraîchissement. La sortie des moyens de décodage MDEC est reliée à un registre MANX par l'intermédiaire d'un bus DO4.

Le registre MANX est commandé par les moyens de commande FSM.

Le registre MANX reçoit la page de test sauvegardée mot par mot pour pouvoir effectuer la comparaison avec le mot testé, rafraîchi à une fréquence plus faible.

En variante, la taille du registre MANX peut être adaptée pour pouvoir recevoir plusieurs mots (ou encore toute la page de test sauvegardée), notamment dans le cas où la lecture est effectuée selon le mode dit « Rafale », (« Burst » en langue anglaise), c'est-à-dire lorsque plusieurs mots d'une même page sont lus successivement.

La sortie du registre MANX est connectée à des moyens de comparaison bit-à-bit MCOMP. Ces derniers reçoivent également en parallèle les données directement délivrées en sortie de la mémoire MMV par le bus DO2.

Les moyens de comparaison bit-à-bit MCOMP comparent le contenu du registre MANX, c'est-à-dire la page-mémoire modèle, et les données délivrées par le bus DO2, c'est-à-dire les données non corrigées et non rafraîchies de la page-mémoire correspondante.

Si les moyens de comparaison MCOMP détectent au plus 1 bit ayant une valeur différente entre le contenu modèle et le contenu non rafraîchi (k bits dans le cas général, avec k≤N, si le code correcteur implémenté dans les moyens de décodage MDEC peuvent corriger N erreurs), celle-ci n'est pas prise en compte, car les moyens de décodage MDEC pourront la corriger lorsque les données de la page mémoire en question seront délivrées hors de la mémoire.

S'il existe plus d'une erreur, l'adresse de la page en question est sauvegardée dans une autre mémoire, dite mémoire de pages faibles.

La page en question sera alors rafraîchie à la fréquence de rafraîchissement maximale, alors que les autres pages mémoire continuent d'être rafraîchie à la même fréquence de rafraîchissement.

A cet effet, le dispositif DMV comprend une mémoire statique MPF formant la mémoire de pages faibles.

La mémoire de pages faibles MPF est cadencée par un signal d'horloge CKA élaboré à partir du signal d'horloge CK, qui est délivré à un diviseur par A.

La valeur de A est fixée pour que la fréquence du signal CKA permette de rafraîchir la mémoire à la fréquence de rafraîchissement maximale, c'est-à-dire pour un temps de rétention des cellules-mémoire minimal.

Un compteur/diviseur par Nmax, MADR2, balaie donc les Nmax adresses de la mémoire MMV à la fréquence maximale de rafraîchissement, c'est-à-dire Nmax/Tretmin, Tretmin étant le plus faible temps de rétention des cellules-mémoire. Il délivre donc un index ID2 correspondant à une page-mémoire de la mémoire MMV.

L'index ID2 délivrée par le compteur/diviseur MADR2 est comparé par un comparateur CMP3 au contenu d'un registre MADR3 qui mémorise le nombre de pages faibles actuellement stockées dans la mémoire MPF.

Tant que l'index ID2 est inférieur au nombre de pages faibles stockées dans la mémoire MPF, les moyens de commande FSM commandent, à chaque période du signal CKA, la lecture de la mémoire de pages faibles MPF à l'adresse ADR2 donnée par l'index ID2.

L'adresse ADR2 de la page faible est envoyée vers la mémoire MMV par l'intermédiaire du multiplexeur MUX@, et une commande de rafraîchissement de cette page est envoyée par les moyens FSM vers la mémoire MMV, via le multiplexeur MUXRW.

Le registre MADR3 peut être sur décision des moyens de commande FSM initialisé à la valeur « -1 », maintenu à sa valeur courante, ou incrémenté d'une unité.

Par ailleurs, le contenu de ce registre MADR3 est comparé par l'intermédiaire d'un comparateur CMP2, à la taille Vmax de la mémoire MPF (par exemple 100), pour savoir si cette dernière est pleine.

Si la mémoire MPF est pleine, et que les moyens de comparaison MCOMP détectent sur une page de test plus d'une erreur, la fréquence de rafraîchissement est légèrement augmentée et une bascule BS rebouclée sur les moyens de commande FSM mémorisent l'augmentation de la fréquence de rafraîchissement. En variante, il est possible de ne pas augmenter directement la fréquence de rafraîchissement, mais seulement de mémoriser une demande d'augmentation de la fréquence de rafraîchissement (par exemple dans la bascule BS) puis d'augmenter la fréquence de rafraîchissement uniquement lorsque toute la mémoire MMV est testée.

Pour augmenter la fréquence de rafraîchissement, les moyens de commande FSM modifient la valeur de K, à partir de la valeur courante de la fréquence de rafraîchissement, la période de rafraîchissement correspondante étant mémorisée dans un registre RGT.

Pour ce faire, les moyens de commande FSM contrôlent un multiplexeur MUX2 connecté en sortie du registre RGT. La sortie du multiplexeur MUX2 est rebouclée sur le registre RGT de façon à délivrer la nouvelle valeur de la période de rafraîchissement Tref, en fonction de sa valeur précédente.

Les moyens de commande FSM peuvent commander le multiplexeur MUX2 en initialisant la période de rafraîchissement à sa valeur minimale, Tmin, en l'incrémentant d'une constante CH, en la décrémentant d'une constante CB ou en la maintenant à sa valeur courante, toutes ces valeurs étant délivrée à l'entrée du multiplexeur MUX2.

En variante, au lieu d'incrémenter ou de décrémenter la valeur de la période de rafraîchissement, il est possible de la modifier, en lui appliquant un coefficient multiplicatif.

Ces modes de réalisation sont donnés à titre indicatif.

En outre, les moyens de commande FSM veillent à ce que la période de rafraîchissement ne sorte pas de la plage de valeurs autorisées en interdisant toute nouvelle augmentation de cette période si celle-ci est déjà supérieure au seuil SH2, et toute nouvelle diminution si la période est déjà inférieure au seuil SB2.

Enfin, si la mémoire MPF est pleine, que les moyens de comparaison MCOMP détectent sur une page de test plus d'une erreur, et que la fréquence de rafraîchissement est à sa valeur maximale, aucune action n'est effectuée.

A l'issue du test d'une page de test, il est nécessaire de réécrire les données de la page de test dans la mémoire. Pour cela, la sortie du registre MANX est connectée par l'intermédiaire d'un multiplexeur MUX1 à des moyens de codage MCOD, destiné à encoder tous les mots écrits dans la mémoire, en mode normal comme en mode veille.

Ainsi, à l'issue du codage des données, les moyens de codage MCOD réécrivent ces données dans la mémoire vive MMV, par l'intermédiaire d'un bus d'entrée DI.

Les étapes de rafraîchissement et de test décrites ci-dessus sont réalisées en mode veille, un signal d'entrée dans ce mode étant délivré aux moyens de commande FSM.

A l'entrée du mode veille, la valeur de la fréquence de rafraîchissement est initialisée à sa valeur maximale, correspondant au plus mauvais cas de rétention.

A titre indicatif, pour une température de 85 °C, le temps de rétention est dans le pire des cas de l'ordre de 32 ms.

En mode normal, le fonctionnement de la mémoire est géré par un contrôleur classique CTLN.

Dans ce cas, les commandes et adresses des pages mémoire accédées sont transmises à la mémoire MMV par l'intermédiaire des multiplexeurs MUXRW et MUX@.

Par ailleurs, les données lues en mode de fonctionnement normal sont émises vers le contrôleur CTLN via un bus DO3.

Les données écrites dans la mémoire en mode de fonctionnement normal, sont transmises par l'intermédiaire du multiplexeur MUX1, qui reçoit les données sur une deuxième entrée.

Par ailleurs, les moyens de commande FSM reçoivent en entrée une information sur la température extérieure.

Cette information traduit la variation de la température, en particulier son augmentation. Si la température augmente rapidement, les moyens de commande vont automatiquement forcer la température de rafraîchissement à sa valeur maximale.

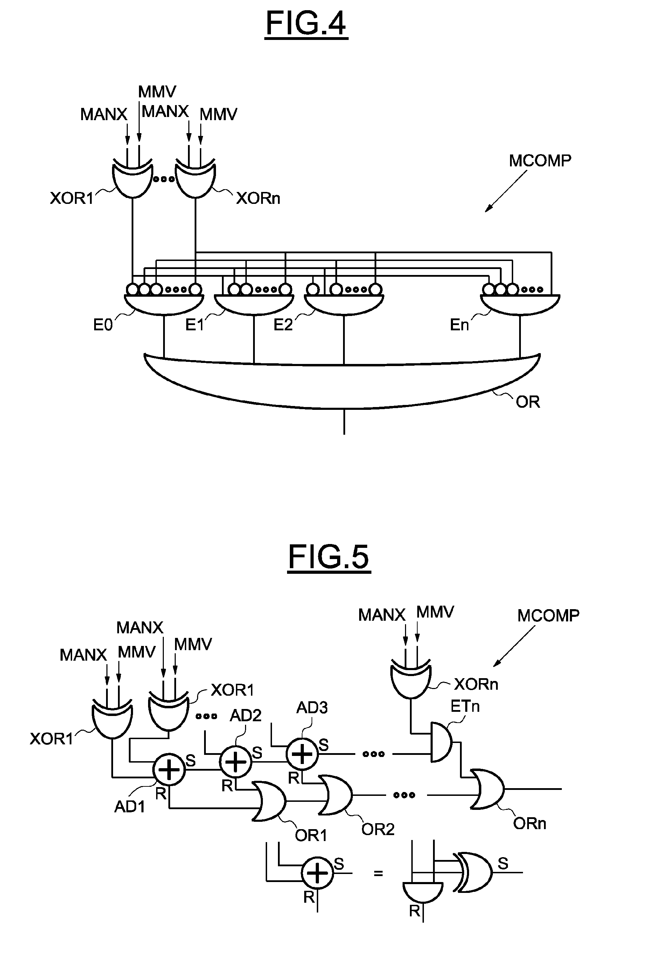

On se réfère à présent plus particulièrement à la figure 4, qui représente un organigramme décrivant les différents états des moyens de commande FSM qui peuvent être réalisés sous la forme d'une machine d'état fini.

Sur cette figure, et dans cet exemple de mise en oeuvre, N désigne l'adresse de pages mémoire (N≤Nmax), P désigne l'adresse d'un mot dans une page et Q désigne la période de latence, c'est-à-dire le nombre de cycles de rafraîchissement entre l'écriture du contenu de test dans une page de test et la lecture du contenu de cette page de test en vue de la comptabilisation des erreurs par les moyens MCOMP. Q est par exemple égal à 2.

Par ailleurs, l'organigramme de la figure 4 correspond, pour des raisons de simplification, au cas où le nombre de pages de test est égal à 1 (plus généralement, le test peut être effectué pour plusieurs pages simultanément). Et, Ntest désigne l'adresse de la page de test courante.

Enfin, T désigne le temps courant, compté en nombre de cycles, depuis le dernier rafraîchissement.

A l'entrée dans le mode « veille », la première page de la mémoire MMV est utilisée comme page de test, et BS est mis à 0 (Ntest = 0 ; BS<-0 ; étape 30).

Les variables N, P et Q sont initialisées également à zéro (étape 31).

Comme indiqué ci-avant, la période de rafraîchissement Tref est mise à la valeur minimale (fréquence Fref maximale), correspondant à la température maximale d'utilisation du système.

Au commencement de la période de test, on corrige une erreur éventuelle pour chaque mot de la page de test et on sauvegarde l'ensemble des mots corrigés de Ntest dans la zone de mémoire sûre (correction et sauvegarde des mots de N test ; étape 32).

Comme Ntest est égal à zéro, on passe directement à une étape 34 où l'on incrémente N d'une unité (N=N+1 ; étape 34), puis au cours d'une étape 35, on rafraîchit successivement toutes les autres pages de la mémoire vive, c'est-à-dire tant que N est différent de Nmax, et à la période de rafraîchissement Tref (rafraîchissement page N, N=N+1 ; étape 35).

Puis lorsque N est égal à Nmax, au cours d'une étape 36, on ré-initialise N à 0, et l'on incrémente la variable Q d'une unité. Si Q est inférieur à sa valeur maximale, comme Ntest est égal à zéro, on réitère les étapes 34 à 36 tant que Q est différent de Qmax.

Lorsque Q atteint sa valeur maximale Qmax, on initialise au cours d'une étape 37 la variable P.

Puis au cours d'une étape 38, on lit le premier mot de la page test modèle (lecture de la sauvegarde du mot P de Ntest ; étape 38).

On lit alors le contenu du même mot P de Ntest non corrigé et non rafraîchi, que l'on compare au contenu modèle du mot. A l'issue de la comparaison, on repère s'il existe plus d'une erreur, qui ne pourront donc pas être corrigées par le code correcteur d'erreurs. On incrémente P d'une unité (lecture mot P de Ntest, comptage des erreurs ; P=P+1 ; étape 39).

Puis tant que P est différent de Pmax, on réitère les étapes 38 et 39.

Lorsque P atteint sa valeur maximale, si aucun mot de la page ne comporte plus d'une erreur, aucune action n'est réalisée puisque le code correcteur est capable de corriger une éventuelle erreur par mot.

Si au moins 1 mot de la page comporte plus d'une erreur, que la mémoire de pages faibles n'est pas pleine et que la fréquence de rafraîchissement n'est pas à sa valeur maximale, l'adresse de la page testée est mémorisée dans la mémoire de pages faibles MPF et le registre MADR3 est mis à jour (étape 40b ; mise à jour MPF est MADR3).

Si au moins 1 mot de la page comporte plus d'une erreur et que la mémoire de pages faibles est pleine, on augmente la fréquence de rafraîchissement et la bascule BS mémorise cette augmentation (étape 40a, mise à jour de BS et augmentation de Fref).

Puis, au cours d'une étape 41, on code le contenu modèle sauvegardé dans la zone de mémoire sûre et on le réécrit dans la mémoire MMV à l'adresse Ntest (encodage et écriture du contenu modèle dans Ntest ; étape 41).

Comme Ntest est différent de Nmax, on incrémente la valeur de Ntest d'une unité (Ntest=Ntest+1, modulo Nmax ; étape 42).

Puis l'on réitère les étapes 31 et 32.

A l'issue de l'étape 32, comme Ntest est différent de zéro, on passe à l'étape 33 où l'on rafraîchit la page mémoire à l'adresse N et on incrémente N d'une unité (rafraîchissement page N, N=N+1 ; étape 33). Tant que N est différent de Ntest et à la période de rafraîchissement Tref, on réitère l'étape 33.

Si N est égal à Ntest, on incrémente directement la valeur de N d'une unité au cours de l'étape 34 sans rafraîchir la page de test considérée.

Puis on passe à une étape 35 où l'on rafraîchit de nouveau la page N et on incrémente la valeur de N d'une unité (rafraîchissement page N, N=N+1 ; étape 35).

On répète l'étape 35 avec une période de rafraîchissement Tref et tant que N est différent de Nmax.

A l'issue de l'étape 35, on réitère les étapes 36 à 41 telles que décrite ci-avant.

Lorsque Ntest est égal à Nmax à l'issue de l'étape 41, toutes les pages ont été testées. On met alors à jour la mémoire de pages faibles MPF et les moyens d'adressage MADR3 de la manière suivante :
- si BS= « 1 », indiquant que l'on a déjà dû augmenter la fréquence de rafraichissement au cours du cycle de test, et que la fréquence de rafraîchissement est à sa valeur maximale : la mémoire de pages faibles MPF est pleine, elle est alors vidée ; pour cela le registre MADR3 est remis à sa valeur initiale, -1 (étape 43a, MPF vidée, MADR3<- « -1 », BS<-« 0 »), ( en effet, si l'on entre dans le mode veille alors que la température est très élevée, il risque d'y avoir trop de pages pour lesquelles on ne pourra pas baisser la fréquence de rafraîchissement ; les adresses de pages mémorisées dans MPF ne correspondront pas nécessairement à celles des pages les plus faibles. Il vaut mieux alors recommencer le test jusqu'à temps que la température ait baisse suffisamment pour que l'on puisse fonctionner avec une mémoire de pages faibles idéalement remplie),
- si la bascule BS indique que l'on n'a pas augmenté la fréquence de rafraîchissement (BS=« 0 »), durant le test de la mémoire et que celle-ci est supérieure à sa valeur minimale (Fref>Frefmin), on diminue légèrement cette fréquence (étape 43b, Fref--),
- dans les autres cas BS est remise à 0 (étape 43c;

BS<-0) et aucune autre action n'est effectuée.

Puis c'est de nouveau la première page de la mémoire qui devient la page de test (Ntest=Ntest+1 modulo Nmax, étape 42) et les opérations décrites précédemment sont à nouveau effectuées successivement pour toutes les pages de la mémoire de façon à réaliser un nouveau cycle de régulation de la période de rafraîchissement.

On se rapporte à présent aux figures 4 à 6 qui représentent des modes de réalisation des moyens de comparaison MCOMP, pour tester un mot.

La figure 4 illustre un mode de réalisation dit « parallèle ». Dans ce cas, les moyens de comparaison MCOMP, comprennent n+1 portes logiques « ET », E0, E1, E2...En, n correspondant au nombre de bits par mot.

La porte logique EO comprend n entrées inverseuses.

Chaque porte logique Ek comprend n-1 entrée inverseuses, la k^{ième} entrée étant non-inverseuse, k variant de 1 à n.

Chaque entrée de la porte logique Ek est connectée à la sortie d'une porte logique « OU EXCLUSIF », respectivement XOR1, .....XORn.

Chacune de ces portes logiques « OU EXCLUSIF » reçoit pour un mot testé, un bit de ce mot issu du registre MANX et un bit de ce mot issu directement de la mémoire MMV après la période de latence.

S'il existe une différence entre ces deux bits, la porte logique XOR1 délivre la valeur « 1 », et « 0 » sinon.

La première porte E0 permet de repérer s'il n'y a aucune erreur. La deuxième porte E1 repère s'il y a une erreur sur le premier bit, et la porte Ek repère s'il y a une erreur sur le k^{ième} bit.

L'ensemble des sorties des portes E0, ...En sont connectées à une porte logique « OU » référencée OR qui indique la présence d'une erreur multiple si la valeur qu'elle délivre est égale à « 0 ».

Il est possible de connecter un inverseur à la sortie de la porte « OU », pour qu'il délivre un signal indiquant la présence d'au moins deux erreurs.

La figure 5 illustre un autre mode de réalisation des moyens de comparaison MCOMP également de type parallèle.

Dans ce mode de réalisation, les moyens MCOMP comprennent n-2 demi-additionneurs AD1, AD2, AD3, ..., ADn-2 connectés en série, et une porte logique « ET », référencée ETn, qui représente une forme simplifiée d'un demi-additionneur.

Le premier demi-additionneur AD1 reçoit la sortie des deux portes logiques « OU EXCLUSIF », XOR1 et XOR2 décrites précédemment.

Puis chaque demi-additionneur ADi suivant, i variant de 2 à n-2, reçoit en entrée d'une part le signal de sortie de la porte « OU EXCLUSIF » suivante, référencée XORi+1, et d'autre part, la sortie S du demi-additionneur ADi-1 connecté en amont.

La porte logique « ET », ETn, reçoit le signal de sortie de la porte logique XORn, et le signal de sortie du demi-additionneur ADn-2.

En outre, chaque demi-additionneur ADi délivre une retenue R.

Les moyens de comparaison MCOMP comprennent également n-2 portes « OU logique » aptes à recevoir la retenue R d'un demi-additionneur et la sortie de la porte OU logique précédente. La première porte logique « OU » reçoit les retenues des 2 premiers demi-additionneurs. La dernière porte logique « OU », ORn reçoit en entrée le signal délivré par la porte logique « OU » précédente ORn-1 et la sortie de la porte ETn.

Bien entendu, il est possible de remplacer les n portes logiques « OU » par une seule porte logique « OU » à n-1 entrées, recevant toutes les sorties R des demi-additionneurs ainsi que la sortie de la porte ETn.

Les retenues sont successivement additionnées les unes aux autres à l'aide de portes logiques « OU », OR1, ..., ORn, et si l'une quelconque des retenues R passe à « 1 », la sortie de la porte « OU » concernée passe à « 1 », ce qui signifie qu'il y a au moins deux erreurs.

Classiquement, un demi-additionneur peut être réalisé à l'aide d'une porte logique « OU EXCLUSIF » (comme représenté sur la figure 5) pour la somme S de sortie et d'une porte logique « ET » logique pour la retenue R. Cependant, la porte « OU EXCLUSIF » pour la somme S peut être remplacée dans ce cas d'utilisation par une simple porte logique « OU ».

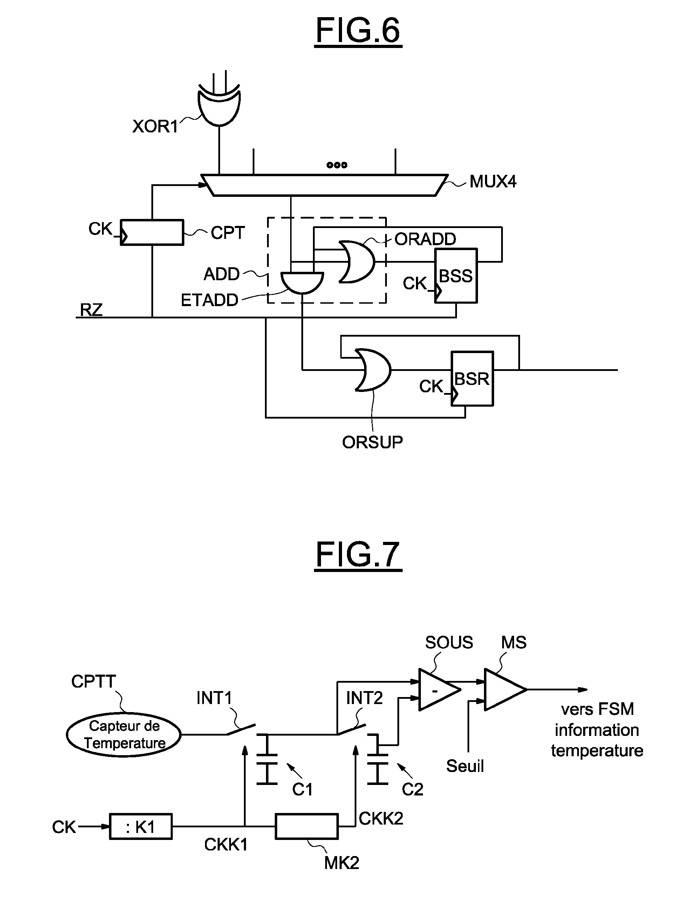

La figure 6 représente un mode de réalisation dit « série » des moyens de comparaison MCOMP. Un multiplexeur MUX4 commandé par un compteur CPT qui est cadencé par le signal d'horloge CK.

Le multiplexeur MUX4 reçoit les sorties des portes logiques XOR1, ....XORn.

Le compteur CPT cadence le multiplexeur MUX4 de façon à sélectionner successivement les différentes entrées.

Chaque bit d'entrée est alors délivré à un demi-additionneur ADD couplé à une bascule BSS.

Dans cet exemple, le demi-additionneur ADD comprend une porte logique « ET », ETADD, et une porte logique « OU », ORADD, couplés en parallèle. Les portes ETADD et ORADD reçoivent en entrée la sortie du multiplexeur MUX4 et la sortie de la bascule BSS.

La sortie de la porte logique ORADD est connectée à l'entrée de la bascule BSS.

La sortie de la porte logique ETADD est connectée à une autre bascule BSR, via une porte logique « OU », ORSUP, qui reçoit également en entrée la sortie de la bascule BSR.

Si le bit délivré en entrée est à « 1 » ou que le résultat précédent mémorisé par la bascule BSS est déjà à « 1 », la bascule BSS est mise à « 1 », indiquant la présence d'au moins un bit à « 1 ». Si le bit délivré en sortie du multiplexeur MUX4 est à « 1 » et que la bascule BSS est déjà à « 1 », la bascule BSR est mise à « 1 ». Si la bascule BSR était déjà à « 1 », elle conserve ce résultat, ce qui indique la présence d'au moins deux erreurs.

Les bascules BSS et BSR sont cadencées par le signal d'horloge CK et peuvent être remises à zéro par un signal de remise à zéro RZ.

Les modes de réalisation des moyens de comparaison décrits ci-avant sont adaptés au cas où le code correcteur d'erreurs ne corrige qu'une seule erreur. L'homme du métier saura adapter les moyens de comparaison dans le cas où le code correcteur d'erreurs corrige k erreurs.

La figure 7 représente un exemple de réalisation des moyens de détection de la variation de la température.

Ces moyens comprennent un capteur de température CPTT ainsi que deux moyens d'échantillonnage, chacun étant formé d'un interrupteur respectivement INT1, INT2 associé à un condensateur respectivement C1 et C2. Les interrupteurs peuvent être par exemple réalisés au moyen de transistors.

Les interrupteurs INT1 et INT2 sont commandés par deux signaux d'horloge CKK1 et CKK2, en opposition de phase et non-recouvrants. Le signal CKK1 est issu du signal d'horloge CK respectivement divisé par un entier K1 et le signal CKK2 est obtenu à partie du signal CKK1 par l'intermédiaire des moyens MK2 aptes à élaborer et délivrer le signal CKK2 en opposition de phase par rapport à CKK1 et non-recouvrant.

Un soustracteur SOUS compare la différence entre les deux valeurs échantillonnées par les condensateurs C1 et C2. Puis des moyens de seuillage MS comparent cette différence à un seuil prédéfini. Cette information de température est délivrée aux moyens de commande FSM qui décident ou non de forcer l'augmentation de la fréquence de rafraîchissement si la variation est supérieure au seuil choisi.

## Revendications

1. Procédé de rafraîchissement d'une mémoire vive dynamique couplée à un système de correction d'erreur qui utilise un code correcteur d'erreur, ladite mémoire comprenant des groupes de cellules-mémoire aptes à stocker des bits, chaque groupe de cellules-mémoire étant subdivisé en paquets de cellules-mémoire, **caractérisé par le fait qu'**à chaque paquet de cellules-mémoire sont adjoints quelques bits formant ledit code correcteur d'erreur, et qu'on effectue sur chaque groupe de cellules-mémoire, un test de rétention dans lequel
on sauvegarde le groupe sous test dans une zone mémoire sûre, après une correction de ses éventuelles erreurs par ledit système de correction d'erreur, de façon à obtenir un groupe modèle comportant des paquets modèles (étape 32),
on effectue au bout d'une période de latence, une comparaison bit-à-bit entre le groupe modèle et ledit groupe n'ayant ni été corrigé ni rafraîchi pendant ladite période de latence,
on détecte dans chaque paquet dudit groupe, les bits dits erronés ayant des valeurs différentes de celles des bits du paquet modèle correspondant et on considère ledit paquet comme erroné s'il comporte un nombre de bits erronés supérieur à une valeur limite inférieure ou égale au nombre de bits capable d'être corrigés par le système de correction d'erreur (étape 39),
et **par le fait qu'**on augmente la valeur de la fréquence de rafraîchissement de la mémoire, si le nombre de groupes de cellules-mémoire comportant au moins un paquet erroné, est supérieur à un seuil fixé (étape 40a).

2. Procédé selon la revendication précédente, dans lequel le système de correction d'erreur est capable de corriger un bit par paquet de cellules-mémoire.

3. Procédé selon l'une des revendications précédentes, dans lequel ladite période de latence comprend N périodes de rafraîchissement, N étant un entier.

4. Procédé selon l'une des revendications précédentes, dans lequel à l'issue de la détection des bits erronés, on adjoint un code correcteur d'erreur au contenu du groupe de cellules-mémoire modèle, puis on le sauvegarde au sein de la mémoire vive dynamique, à la place du groupe de cellules-mémoire correspondant (étape 41).

5. Procédé selon l'une des revendications 1 à 4, dans lequel tant que le nombre de groupes de cellules-mémoire comportant au moins un paquet erroné, dit groupes de cellules-mémoire faibles, est inférieur ou égal audit seuil fixé, on mémorise l'adresse du groupe de cellules-mémoire faibles pour les rafraîchir à la fréquence maximale (étape 40b).

6. Procédé selon l'une des revendications précédentes, dans lequel l'augmentation est effectuée si la fréquence de rafraîchissement n'a pas atteint sa valeur maximale (étape 40a).

7. Procédé selon l'une des revendications précédentes dans laquelle, lorsque tous les groupes de cellules-mémoire de la mémoire ont été testés, on diminue la valeur de la fréquence de rafraîchissement, si elle n'a pas été augmentée au cours dudit test (étape 43b).

8. Procédé selon l'une des revendications précédentes, dans lequel, lorsque tous les groupes de cellules-mémoire de la mémoire ont été testés, si le nombre de groupes de cellules-mémoire comportant au moins un paquet erroné, dit groupe de cellules-mémoire faibles, est supérieur ou égal audit seuil fixé et si la fréquence de rafraîchissement est à sa valeur maximale, on considère comme nul ledit nombre de groupes de cellules-mémoire faibles (étape 43a).

9. Procédé selon l'une des revendications précédentes, dans lequel on sélectionne successivement chaque groupe de cellules-mémoire formant un groupe de cellules de test, de façon à effectuer ledit test de rétention.

10. Procédé selon la revendication précédente, dans lequel parallèlement au test de rétention, on rafraîchit cycliquement l'ensemble des cellules-mémoire de la mémoire à l'exception du groupe de cellule de test.

11. Procédé selon l'une des revendications précédentes, dans lequel la mémoire est organisée par page et dans lequel chaque groupe de cellules-mémoire correspond à un nombre entier de pages, et chaque paquet de cellules-mémoire correspond à un mot d'une page.

12. Procédé selon l'une des revendications précédentes, dans lequel on impose une augmentation de la fréquence de rafraîchissement si la variation de la température au sein de ladite mémoire dépasse un seuil choisi.

13. Procédé selon l'une des revendications précédentes dans lequel la mémoire est incorporée dans un appareil possédant un mode de veille et un mode de fonctionnement actif, et dans lequel on effectue le test de rétention sur toutes les cellules-mémoire au moins au cours du mode de veille.

14. Procédé selon la revendication précédente, dans lequel ledit appareil est un composant d'un système de communication sans fil, par exemple un téléphone mobile cellulaire.

15. Dispositif de rafraîchissement d'une mémoire vive dynamique (MMV) comprenant des groupes de cellules-mémoire aptes à stocker des bits, chaque groupe de cellules-mémoire étant subdivisé en paquets de cellules-mémoire, **caractérisé par le fait que** la mémoire vive dynamique est couplée à un système de correction d'erreur (MDEC) en vue duquel un code correcteur d'erreurs apte à corriger un nombre donné de bits erronés éventuels par paquet de cellules-mémoire est associé à chaque paquet de cellules-mémoire, et **par le fait que** le dispositif comprend des moyens de test (MTEST) aptes à effectuer un test de rétention sur chaque groupe de cellules-mémoire, comportant
une zone de mémoire sûre apte à sauvegarder le groupe sous test après une correction de ses éventuelles erreurs par ledit système de correction d'erreur, de façon à obtenir un groupe modèle comportant des paquets modèles,
des moyens de comparaison (MCOMP) aptes à effectuer au bout d'une période de latence, une comparaison bit-à-bit entre le groupe modèle et ledit groupe n'ayant ni été corrigé, ni rafraîchi pendant ladite période de latence, et apte à détecter dans chaque paquet dudit groupe, les bits dits erronés ayant des valeurs différentes de celles des bits du paquet modèle correspondant et aptes à considérer ledit paquet comme erroné s'il comporte un nombre de bits erronés supérieur à une valeur limite inférieure ou égale au nombre de bits capable d'être corrigés grâce au code correcteur d'erreur, par le système de correction d'erreur, et **par le fait que** le dispositif comprend des moyens d'augmentation aptes à augmenter la valeur de la fréquence de rafraîchissement de la mémoire, si le nombre de groupes de cellules-mémoire comportant au moins un paquet erroné, est supérieur à un seuil fixé.

16. Dispositif selon la revendication précédente, dans lequel ladite zone de mémoire sûre est une zone réservée de ladite mémoire vive, rafraîchie à la valeur maximale de la fréquence de rafraîchissement, pour sauvegarder le groupe modèle.

17. Dispositif selon la revendication 15, dans lequel ladite zone de mémoire sûre est une mémoire statique annexe couplée à la mémoire vive dynamique (MMV), pour sauvegarder le groupe modèle.

18. Dispositif selon l'une des revendications 15 à 17, comprenant en outre des moyens d'adjonction (MCOD) couplés à ladite mémoire vive dynamique, aptes à adjoindre un code correcteur d'erreur au contenu du groupe de cellules-mémoire modèle, et aptes à sauvegarder le contenu codé du groupe modèle au sein de la mémoire vive dynamique (MMV), à la place du groupe de cellules-mémoire correspondant.

19. Dispositif selon l'une des revendications 15 à 18, comprenant en outre une mémoire de pages faibles (MPF), dont la taille (Vmax) est égale audit seuil, aptes à sauvegarder les adresses des groupes de cellules-mémoire comportant au moins un paquet erroné, dit groupes de cellules-mémoire faibles.

20. Dispositif selon la revendication précédente, dans lequel les groupes de cellules-mémoire faibles sont rafraîchis à la valeur maximale de rafraîchissement.

21. Dispositif selon l'une des revendications 19 ou 20, comprenant en outre des moyens de comparaison (CMP3) aptes à comparer le remplissage de la mémoire de pages faibles et ledit seuil.

22. Dispositif selon la revendication précédente, comprenant en outre des moyens d'enregistrement (BS) aptes à enregistrer la réalisation d'une augmentation de la fréquence.

23. Dispositif selon la revendication précédente, comprenant en outre des moyens de diminution couplés auxdits moyens d'enregistrement (BS), aptes à diminuer la fréquence de rafraîchissement.

24. Dispositif selon l'une des revendications 19 à 23, comprenant en outre des moyens de contrôle (MADR3) de la mémoire de pages faibles, aptes à mettre à jour et à réinitialiser ladite mémoire de pages faibles.

25. Dispositif selon l'une des revendications 15 à 24, dans lequel les moyens de test de rétention comprennent en outre des moyens de sélection (MSEL) aptes à sélectionner successivement les différents groupes de cellules-mémoire, de façon à balayer l'ensemble des cellules-mémoire, les groupes de cellules-mémoire sélectionnés formant des groupes de cellules de test.

26. Dispositif selon l'une des revendications 15 à 25, comprenant en outre des moyens de rafraîchissement (FSM) aptes à rafraîchir cycliquement l'ensemble des cellules-mémoire de la mémoire.

27. Dispositif selon les revendications 25 et 26, comprenant en outre des moyens de comparaison auxiliaires (CMP1) couplés entre les moyens de rafraîchissement et les moyens de test (MTEST) aptes à comparer les adresses du groupe de cellules-mémoire rafraîchi par les moyens de rafraîchissement, et du groupe de cellules de test, de façon que les moyens de rafraîchissement ne rafraîchissent pas le groupe de cellules de test.

28. Dispositif selon l'une des revendications 15 à 27, dans lequel ledit système de correction d'erreur est apte à corriger une erreur par paquet de cellule-mémoire.

29. Dispositif selon la revendication 28, dans lequel chaque paquet de cellules-mémoire comprend n bits, et dans lequel les moyens de comparaison (MCOMP) comprennent, pour chaque paquet d'un groupe de cellules-mémoire, n portes logiques « OU EXCLUSIF » (XORi), chaque porte étant apte à recevoir l'un des bits du paquet modèle et le bit correspondant du paquet n'ayant ni été corrigé ni rafraîchi pendant ladite période de latence, n portes logiques « ET » (Ei) avec n-1 entrées inverseuses, et une porte logique « ET » avec n entrées inverseuses (E0), l'ensemble des portes logiques « ET » étant connectées en parallèle, à la sortie des n portes logiques « OU EXCLUSIF », et une porte logique « OU » (OR) connectée à la sortie de l'ensemble des portes logiques « ET », apte à déterminer s'il existe au moins deux bits différents entre ledit paquet modèle et ledit bit correspondant du paquet n'ayant ni été corrigé ni rafraîchi pendant ladite période de latence.

30. Dispositif selon la revendication 28, dans lequel chaque paquet de cellules-mémoire comprend n bits, et dans lequel les moyens de comparaison (MCOMP) comprennent n portes logiques « OU EXCLUSIF » (XORi), chaque porte étant apte à recevoir l'un des bits du paquet modèle et le bit correspondant du paquet n'ayant ni été corrigé ni rafraîchi pendant ladite période de latence, n-1 demi-additionneurs (ADi) connectés en série et en sortie des portes logiques « OU EXCLUSIF », aptes à recevoir, pour le premier demi-additionneur, les signaux de sortie des 2 premières portes « OU exclusif », et pour les autres, d'une part une somme délivrée par le demi-additionneur connecté en amont, et d'autre part un signal de sortie d'une porte logique « OU EXCLUSIF », chaque demi-additionneur étant apte à délivrer un signal de retenue, et dans lequel les moyens de comparaison (MCOMP) comprennent en outre des moyens d'addition de l'ensemble desdites retenues, aptes à déterminer s'il existe au moins deux bits différents entre ledit paquet modèle et ledit bit correspondant du paquet n'ayant ni été corrigé, ni rafraîchi pendant ladite période de latence.

31. Dispositif selon la revendication précédente, dans lequel les moyens d'addition comprennent une porte logique « OU » dont les entrées sont connectées aux sorties des deux premiers demi-additionneurs et, si n est supérieur à 3, n-3 portes logiques « OU » (ORi) recevant en entrée le signal de sortie de la porte logique « OU » connectée en amont, et la retenue du demi-additionneur associé.

32. Dispositif selon la revendication 28, dans lequel chaque paquet de cellules-mémoire comprend n bits, et dans lesquels les moyens de comparaison (MCOMP) comprennent n portes logiques « OU EXCLUSIF » (XORi), chaque porte étant apte à recevoir l'un des bits du paquet modèle et le bit correspondant du paquet n'ayant ni été corrigé ni rafraîchi pendant ladite période de latence, un multiplexeur commandé par un compteur (CPT) cadencé par un signal d'horloge et couplé à la sortie des n portes logiques « OU EXCLUSIF », un demi-additionneur (ADD) couplé à la sortie du multiplexeur, une première bascule (BSS) connectée à la sortie du demi-additionneur, et dont la sortie est rebouclée à l'entrée dudit demi-additionneur, et une deuxième bascule (BSR) connectée au demi-additionneur par l'intermédiaire d'une porte logique « OU » (ORSUP), apte à déterminer s'il existe au moins deux bits différents entre ledit paquet modèle et ledit bit correspondant du paquet n'ayant ni été corrigé, ni rafraîchi pendant ladite période de latence.

33. Dispositif selon l'une des revendications 15 à 32, dans lequel la mémoire (MMV) est organisée par page et dans lequel chaque groupe de cellules de test correspond à un nombre entier de pages, et chaque paquet de cellules-mémoire correspond à un mot d'une page.

34. Dispositif selon l'une des revendications 26 à 33, comprenant en outre des moyens de commandes (FSM) aptes à commander les moyens de rafraîchissement et les moyens de test de rétention.

35. Dispositif selon la revendication 34, comprenant un capteur de température (CPTT), couplé aux moyens de commande, aptes à détecter une variation de la température.

36. Appareil possédant un mode de veille et un mode de fonctionnement actif, incorporant un dispositif selon l'une des revendications 15 à 35, dans lequel les moyens de test effectuent le test de rétention sur toutes les cellules-mémoire au cours du mode de veille.

37. Appareil selon la revendication précédente, formant un composant d'un système de communication sans fil.

38. Appareil selon la revendication précédente formant un téléphone mobile cellulaire (TP).
